# EUROPÄISCHE PATENTSCHRIFT

(11) **EP 1 052 883 B1**
(45) Veröffentlichungstag und Bekanntmachung des Hinweises auf die Patenterteilung: **14.03.2007**
(21) Anmeldenummer: 00100306.0
(22) Anmeldetag: 07.01.2000
(51) Int. Cl.: H05K 7/14

(54) **Kodiervorrichtung und Kodierverfahren zur Kodierung eines elektrischen Gerätes**
Apparatus and method for coding for an electrical device
Dispositif et procédé de codage pour un appareil électrique

(30) Priorität: 25.01.1999 DE 19902811
(43) Veröffentlichungstag der Anmeldung: 15.11.2000
(73) Patentinhaber: Weidmüller Interface GmbH & Co., 32760 Detmold (DE)
(72) Erfinder: Zebermann, Christoph, 37688 Beverungen (DE); Dux, Dietmar, 32758 Detmold (DE); Wilmes, Manfred, 32760 Detmold (DE); Schnatwinkel, Michael, 32051 Herford (DE); Steinmeier, Rudolf, 32760 Detmold (DE); Hanning, Walter, 32758 Detmold (DE)
(74) Vertreter: Specht, Peter

(56) Entgegenhaltungen:
- DE-A- 19 710 768
- DE-U- 7 823 090
- US-A- 3 491 330
- US-A- 4 895 535
- US-A- 5 392 194

## Beschreibung

Die Erfindung betrifft eine Kodiervorrichtung nach dem Oberbegriff des Anspruchs 1 und ein Kodierverfahren nach dem Oberbegriff des Anspruches 25.

Kodiervorrichtungen sind in den verschiedensten Ausführungsformen bekannt. So zeigt die DE 38 30 187 eine Kodiervorrichtung für Schaltschrankeinschübe zur eindeutigen Zuordnung von Einschüben und Einschubkammern mittels Kodierzapfen am Einschub und damit korrespondierenden Kodiereinrichtungen am Einschubträger. Die Kodierzapfen sind auf der Unterseite eines Einschubbodens senkrecht stehend in einer Reihe mit rechtem Winkel zur Einschubrichtung befestigt. Auf dem Bodenblech des Einschubträgers ist eine Kodierplatte mit in Einschubrichtung liegenden Nuten versehen, deren Abstand mit dem Abstand der Kodierzapfen korrespondiert. Die Kodierzapfen ragen in die Nuten hinein. Kodiersysteme wie dieses haben den Nachteil, daß aufgrund des Montageaufwandes auf die Kodierung in der Praxis oft verzichtet wird. Dies kann jedoch zu Problemen oder Beschädigungen führen, beispielsweise dadurch, daß verschiedene Potentiale (z.B. 24V und 230V) zusammengeführt werden.

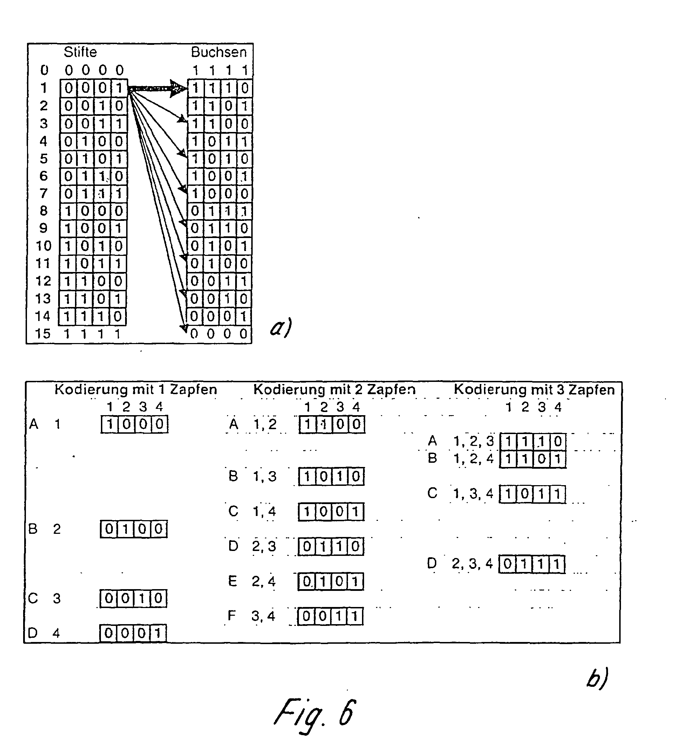

Einen weiteren internen Stand der Technik zeigt Fig. 6. Dieser Stand der Technik bringt das Problem mit sich, daß Kodierungen mit wenigen Zapfen in Kodieraufnahmen mit freien Buchsenlöchem gesteckt werden können. So kann der Stift "1" der Fig. 6 nicht nur in die Buchse "1" sondern auch in die Buchsen "3, 5, 7, 9, 11, 13, 15" gesteckt werden. Damit wird ein Fehlstecken nicht sicher ausgeschlossen. Wie Fig. 6 ferner beispielhaft zeigt, besteht daher das Problem, daß sich bei insgesamt vier Zapfenlagen mit einem und drei Zapfen von den theoretischen sechzehn nur vier wirklich voneinander unterscheidbare Kodiervarianten realisieren lassen. Bei fünf Zapfenlagen gibt es nur zehn echte Unterscheidungsmöglichkeiten.

Aus der US-A- 5 392 194, der US-A-4 895 535 und der US-A-3 491 330 sind jeweils Kodiervorrichtungen aus Kodierelementabschnitten mit ineinander greifenden Zapfen und Ausnehmungen bekannt, wobei die Zapfen verschiedener Kodierelemente nach Art einer umlaufenden Rotation zueinander winkelversetzt angeordnet sind.

Die DE 78 23 090 U zeigt eine weitere Kodiervorrichtung aus Kodierelementabschnitten mit ineinander greifenden Zapfen und Ausnehmungen, die bei verschiedenen Varianten zueinander versetzt angeordnet und ausgerichtet sind.

Die Erfindung setzt ausgehend von diesem Stand der Technik bei der Aufgabe an, eine Kodiervorrichtung zu schaffen, die eine unkomplizierte und schnelle Montierbarkeit gewährleistet. Dabei soll bei Weiterbildungen auch eine hohe Kodiersicherheit und eine hohe Anzahl auch auf engem Raum realisierbarer Kodiervarianten realisiert werden.

Die Erfindung löst diese Aufgabe durch den Gegenstand des Anspruchs 1. Sie schafft zudem das Verfahren des Anspruchs 25.

Vorzugsweise weist der Kodierelementabschnitt des ersten Bauteiles wenigstens einen Zapfen auf, der dazu ausgelegt ist, beim Zusammensetzen der beiden Bauteile an einem entsprechenden Zapfen oder in einer entsprechenden Buchse des Kodierelementabschnittes des zweiten Bauteiles geführt zu werden, wobei die zusammensteckbaren Zapfen und/oder Buchsen jeweils im wesentlichen einen mehreckigen Querschnitt aufweisen und einen Teil einer Grundfläche - insbesondere ein regelmäßiges Vieleck oder eine Kreisfläche - bilden, auf der sie nach einem Kodiersystem ausgerichtet sind, bei welchem die Zapfen des ersten und die Zapfen und/oder Buchsen des zweiten Kodierelementes jeweils mit einer ihrer Außenseiten im wesentlichen am Umfang der Grundfläche anliegen und bei verschiedenen Kodierelementvarianten am Umfang der Grundfläche umlaufend rotieren bzw. zueinander verdreht sind. Dieses Kodiersystem gewährt eine hohe Kodiervariantenzahl bei einem Ausschluß von Verwechslungen. Insbesondere auch dann, wenn zwei oder mehr dieser Grundflächen bzw. Vielecke direkt aneinandergereiht werden, ergibt sich in Verbindung mit der eindeutigen Positionszuordnung (Verdrehsicherung) der beiden mit der Kodiervorrichtung zu versehenen Bauteile auf engstem Raum eine besonders hohe Zahl von verschiedenen stecksicheren Kodiervarianten.

Vorzugsweise weisen die zusammensteckbaren Zapfen und/oder Buchsen jeweils im Wesentlichen einen rechteckigen Querschnitt auf, der ungefähr die halbe Fläche der als Quadratbereich ausgebildeten Grundfläche beträgt.

Es ist zudem zweckmäßig, wenn jeweils eine der Längsseiten der rechteckigen Zapfen oder Buchsen an einer der Außenseiten des Quadratbereiches liegt und/oder sich die Flächen der verschiedenen Zapfen-/Zapfen oder Zapfen-/Buchsenkombinationen teilweise überlappen. Dieses Kodiersystem ermöglicht auf einem einzigen Quadratbereich - mit einer z.B. nur wenige mm betragenden Kantenlänge - die Realisierung vier verschiedener Kodiervarianten, wobei sich die Anzahl der Kodiervarianten durch eine Reihung dieser Quadratbereiche zur Aufnahme der rechteckigen Zapfen und Buchsen vervielfachen läßt. So sind mit zwei aneinandergereihten Bereichen auf engem Raum bereits sechzehn und mit drei in einer Reihe aneinander gesetzten Bereichen sogar vierundsechzig Kodiervarianten auf einer besonders schmalen Fläche realisierbar.

Bei einer weiteren bevorzugten Ausfiihrungsform, die auf einer Grundfläche noch mehr Kodiervarianten realisiert, ist die Grundfläche als Sechseck ausgebildet, wobei die Zapfen als halbe Sechseckfläche oder als Drittel der Sechseckfläche (135°-Element) ausgestaltet sind und für verschiedene Kodiervarianten die Stifte jeweils in 60°- Schritten am Außenumfang zueinander versetzt sind. Diese Idee läßt sich mit beliebigen Sechsecken fortführen, wobei mit zunehmender Eckenzahl die Kodiervariantenvielfalt auf einer Grundfläche zwar theoretisch erhöht werden kann. Irgendwann ergibt sich jedoch bei gleich groß bleibender Grundfläche das Problem nur noch wenig unterschiedlicher Zapfenpositionen.

Die Erfindung löst darüber hinaus nach einer besonders bevorzugten Ausführungsform noch ein weiteres Problem. Bei elektrischen Geräten, bei denen ein allen Geräten einheitliches erstes Bauteil mit verschiedenen zweiten Bauteilen zu kombinieren ist, also z.B. bei elektrischen Geräten, die auf Klemmenträgern aufbauen, welche mit unterschiedlichen Elektronikgehäusen zu versehen sind, wird nämlich durch die Kodiervorrichtungen die Lagerhaltung erschwert, da zu jedem Elektronikgehäuse mit dem ersten Kodierelementabschnitt ein dazu passender Klemmenkörper mit dem korrespondierenden zweiten Kodierelementabschnitt vorrätig zu halten ist.

Dieses Problem wird dadurch gelöst, daß die beiden Kodierelementabschnitte gemeinsam an das erste Bauteil ansetzbar und derart ausgelegt sind, daß beim Zusammenfügen der beiden Bauteile der zweite Kodierelementabschnitt derart an das zweite Bauteil anrastet, daß beim Trennen der beiden Bauteile voneinander der zweite Kodierelementabschnitt am zweiten Bauteil verbleibt, so daß er ein Gegenstück für den beim Trennen der zwei Bauteile am ersten Bauteil verbleibenden ersten Kodierelementabschnitt bildet.

Beispielsweise wird - und für diese Ausführungsform eignet sich die Erfindung besonders - der zweite am Basis-Klemmenkörper befestigte Kodierelementabschnitt derart ausgebildet, daß er beim Aufsetzen des Gehäuses auf ein Basisbauteil, z.B. den Basis-Klemmenträger, in eine Ausnehmung einrastet, in der er nach einem Abnehmen des Gehäuses vom Basis-Klemmenträger verbleibt, so daß er das Gegenstück für den beim Abziehen des Elektronikgehäuses am Elektronikgehäuse verbleibenden ersten Kodierelementabschnitt bildet. Anders als beim Stand der Technik bietet sich hierdurch der Vorteil, daß eines der beiden Bauteile, insbesondere die Basis-Klemmenkörper, bei ihrer Herstellung mit keiner Kodiervorrichtung bzw. mit keinem der Kodierelementabschnitte versehen werden müssen, so daß die Lagerhaltung dieser Bauteile wesentlich vereinfacht wird. Die Elektroniken verschiedenen Typs - z.B. Elektroniken zur Realisierung der Kommunikation zwischen einem externen Feldbus und Aktoren, Initiatoren usw. - werden dagegen jeweils mit einem unterschiedlichen zweiteiligen Kodierelement versehen, wobei der zweite Kodierelementabschnitt erst beim ersten Aufsetzen der Elektronik auf den Basis-Klemmenkörper auf diesen "abgesetzt" wird. Bei einem späteren Auswechseln der Elektronik verbleibt der zweite Kodierelementabschnitt am Basis-Klemmenkörper und schützt das aus dem Basis-Klemmenkörper gebildete elektrische Gerät dann gegen ein versehentliches Aufsetzen einer "falschen" Elektronik mit einer nicht passenden Kodierung. Besonders vorteilhaft kombiniert wird diese Idee mit dem erfindungsgemäßen, auf engem Raum realisierbaren Kodiersystem.

Vorzugsweise sind die beiden Kodierelementabschnitte jedes Kodierelementes einstückig über Einschnürungen bzw. Abrißkanten mit einem flexiblen Grundkörper, insbesondere einem Griff - verbunden, an dem die beiden Kodierelementabschnitte zu einem Kodierelement zusammenfügbar sind. Der Griff wird vorzugsweise als von Hand verbiegbarer Kunststoffbügel ausgebildet. Da der Kunststoffbügel derart bemessen ist, daß die beiden zueinander gehörigen Kodierelementabschnitte der Kodierelemente jeweils am Bügel zu dem Kodierelement zusammenfügbar sind, werden Verwechslungen bei der Montage sicher ausgeschlossen. Zudem ergibt sich eine einfache Handhabung und es wird vermieden, daß jeweils zwei zueinander passende Elemente bei der Montage zusammengesucht werden müssen. Unterstützt wird die hohe Montagesicherheit durch eine am Griff aufgebrachte Beschriftung.

Ein weiterer Vorteil der Erfindung ergibt sich durch die Möglichkeit der leichten Herstellung der verschiedenen Kodiervorrichtungen des Kodiersystems. Dazu wird vorzugsweise zur Herstellung der verschiedenen Varianten von Kodierelementabschnitten eine einzige Gußform mit einer der Anzahl an Kodiervarianten entsprechenden Anzahl an Ausnehmungen vorgesehen, so daß sämtliche Varianten in nur einem Arbeitsgang herstellbar sind. Weiter vereinfacht wird die Herstellung dadurch, daß für die verschiedenen Kodierelemente entsprechend zu ihrer Häufigkeitsverteilung verschieden viele der Ausnehmungen in der Gußform ausgebildet sind. Besonders bevorzugt werden die verschiedenen Kodiervarianten in der Gußform ihrer Häufigkeit beim jeweiligen Einsatzweck zu Gruppen zusammengestellt (z.B. drei Gruppen: besonders oft benötigte Kodiervarianten, normal häufige Varianten, seltene Varianten). Damit wird bei Verwendung nur eines einzigen Werkzeuges das unnütze Herstellen wenig oft vorkommender Varianten vermieden.

Weitere vorteilhafte Ausführungsformen der Erfindung sind den übrigen Unteransprüchen zu entnehmen.

Nachfolgend wird die Erfindung unter Bezug auf die Zeichnung anhand von Ausführungsbeispielen näher beschrieben. Es zeigt:
Fig. 1 eine Sprengansicht einer Modulscheibe eines elektrischen Gerätes mit einer erfindungsgemäßen Kodiervorrichtung;
Fig. 2 eine Seitenansicht von Elementen der Modulscheibe aus Fig. 1 zur Veranschaulichung der Funktion des Kodierelementes sowie eine vergrößerte perspektivische Ansicht des Kodierelementes;
Fig. 3a-d und 4 schematische Darstellungen des Funktionsprinzips weiterer Varianten von erfindungsgemäßen Kodiervorrichtungen ;
Fig. 5a-e wesentliche Schritte des Ablaufes bei der Montage der Kodiervorrichtung am elektrischen Gerät;
Fig. 6 eine Kodiervorrichtung nach dem Stand der Technik.

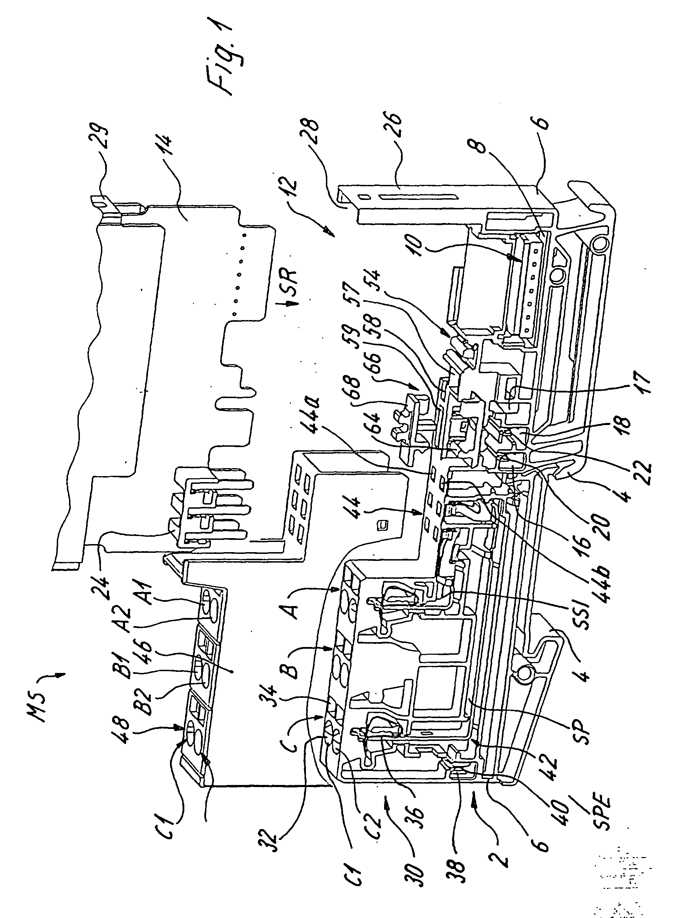

Fig. 1 zeigt eine Modulscheibe MS für ein hier ansonsten nicht dargestelltes Gerät der Automatisierungstechnik. Das Gerät umfaßt ein Gateway (hier nicht dargestellt), an welches u.a. die Modulscheiben MS anreihbar sind. Die Modulscheibe MS ist mit weiteren Modulscheiben MS zu einem Anschlußblock variabler Länge zusammenfügbar.

Die Modulscheibe MS weist nach Fig. 1 einen scheibenförmigen Basis-Klemmenträger 2 zur Verriegelung des Einzelmoduls auf einer (hier nicht dargestellten) Tragschiene auf. Der Basis-Klemmenträger 2 ist hierzu mit Kunststoff-Rastfüßen 4 versehen, mit denen in an sich bekannter Weise die Rastverbindung zur Tragschiene herstellbar ist. Der Basis-Klemmenträger 2 umfaßt einen unteren Basisabschnitt 6, welcher sich in einen Bereich oberhalb der Tragschienenfüße 4 und neben den Tragschienenfüßen 4 beidseits seitlich über die Tragschiene hinaus erstreckt. In dem Basisabschnitt 6 ist in dem einen von der Tragschiene abgewandt liegenden Außenbereich eine den Basis-Klemmenträger 2 senkrecht zu seiner Haupt-Erstreckungsebene durchdringende Busleiteröffnung 8 zur Aufnahme des internen Busleiterabschnitts 10 vorgesehen, der eine Weiterleitung der Busleitersignale von Einzelmodul zu Einzelmodul und in die Elektronikleiterplatte 14 erlaubt.

Zur Aufnahme der Elektronik-Leiterplatte 14 ist in dem Bereich, welcher sich ungefähr von der Senkrechten zur Mitte der Tragschiene bis zu dem internen Busleiterabschnitt 10 erstreckt, in dem Basis-Klemmenträger 2 eine Umfangs-Ausnehmung 12 ausgebildet. Die Elektronikleiterplatte 14 ist mit einer (hier nicht dargestellten) Elektronikschaltung zur Verarbeitung/Weiterleitung der jeweils zur Elektronikleiterplatte 14 geführten Signale versehen.

In dem zwischen dem internen Busleiterabschnitt 10 und dem Rastfuß 4 liegenden Bereich ist der Basisabschnitt 6 mit drei weiteren, nebeneinander liegenden Öffnungen 16, 17, 18 versehen, die jeweils senkrecht zur Hauptscheiben- bzw. -modulebene den Basis-Klemmenträger 2 durchdringen und von denen zwei Öffnungen 16, 18 mit als vorzugsweise einstückigen Querbrückern ausgelegten Kontaktelementen 20, 22 (auf der einen Seite mit einem Steckerstift 20a, 22a, auf der anderen mit dazu passender, einstückig angeformter Buchse 20b, 22b sowie daran angeformten Kontaktaufnahmen 20c, 22c senkrecht nach oben) versehen sind, welche eine Weitergabe der zugeordneten Potentiale - vorzugsweise des Plus- oder Minus-Versorgungspotentiales - von Modul zu Modul ermöglichen. In ihrem Zusammenspiel bilden die Kontaktelemente 20, 22 Potentialführungen. Die weitere Öffnung 17 dient - wie weitere der hier nicht beschriebenen Öffnungen im Basis-Klemmenträger - lediglich der Materialersparnis. Von den Querbrückern 20, 22 werden diese Potentiale in die Leiterplatte und/oder über einen geeigneten separaten oder an die Elektronikleiterplatte angesetzten Stecker 24 zu den Anschlüssen der Stromschienen SM, SP im Basis-Klemmenträger 2 und über diese zu den Anschlußebenen der Modulscheibe MS geführt.

Die Ausnehmung 12 wird an dem von der Tragschiene abgewandten Ende des Einzelmodules von einem senkrecht vom Basisabschnitt abstehenden Steg 26 begrenzt, der an seiner zur Tragschiene 4 gewandten Seite mit einer Einschubnut 28 zum Einschieben der Elektronik-Leiterplatte 14 sowie eines Elektronikgehäuses 29 versehen ist.

Ungefähr an dem dem Steg 26 gegenüberliegenden Ende des Basis-Klemmenträgers 2 ist an den Basisabschnitt 6 ein senkrecht nach oben vorstehender Anschlußabschnitt 30 angeformt, der mit den sechs in zwei Reihen zu je drei angeordneten Einzel- (A1, A2) und Doppel-Anschlüssen B1, B2, C1, C2 versehen ist. Öffnungen 34 mit quadratischem Querschnitt neben Anschlußöffnungen 32 für die Anschlüsse A1, A2, B1, B2 ... erlauben das Einführen eines Schraubendrehers zum Öffnen der im Anschlußabschnitt 30 angeordneten Feder-Kontaktelemente 36. Außerhalb der dritten Anschlußebene C ist im Basisabschnitt eine weitere senkrecht zur Modulscheibenebene liegende, den Basis-Klemmenträger 2 durchdringende Öffnung 38 vorgesehen, in welcher ein weiteres Kontaktelement 40 liegt, über das der Schutzleiter PE von Einzelmodul zu Einzelmodul weitergegeben wird.

Die leitende Verbindung zwischen den Kontaktfedern 36 der Anschlüsse A, B, C, ... und der Elektronikleiterplatte 14 wird mittels Stromschienen SM (für das Minuspotential, hier nicht zu erkennen), SP (für das Pluspotential), SSI (für das Signal) realisiert, die jeweils zunächst von den Kontaktfedern 36 im Anschlußbereich 30 des Basis-Klemmenträgers 2 senkrecht nach unten bis in den Basisabschnitt 6 verlaufen und dann im Basisabschnitt 6 zur Elektronikleiterplatte 14 geführt werden. Die Stromschienen SM, SP verlaufen von den Kontaktfedern 36 in seitlichen Nuten/Ausnehmungen 42 des Grundelementes 2 im wesentlichen u-förmig an beiden Hauptaußenflächen des Basis-Klemmenträgers 2. Unterhalb der Aussparung 12 für die Elektronik-Leiterplatte sind die Stromschienen nach oben hin abgewinkelt und verlaufen zur Umfangs-Ausnehmung 12, welche in diesem Bereich mit sechs in zwei Reihen nebeneinander liegenden Anschlußöffnungen 44 zum Aufsetzen des Gerätesteckers 24 an der Elektronikleiterplatte und/oder des Leiterplattenrandes versehen ist. Die Endbereiche der Stromschienen SSI, SM, SP sind als Stanz-Biegeteilbuchsen ausgeführt und bilden selbst die Anschlußbuchsen für den Gerätestecker 24 zur Elektronikleiterplatte 14 und/oder zum Leiterplattenrand.

Eine besonders raumsparende Anordnung der Stromschienen wird dadurch erreicht, daß die eine der potentialtragenden Stromschienen SM auf der einen Außenseite und die andere potentialtragende Stromschiene SP auf der anderen Außenseite des Basis-Klemmenträgers 2 geführt ist. Erst im Bereich der Anschlußfedern 36 erfolgt die Durchkontaktierung zwischen den beiden in einer Anschlußebene B oder C nebeneinander liegenden zwei Doppelanschlüssen B1 und B2 usw..

Über den Anschlußabschnitt 30 ist ein Abdeckgehäuse 46 aus Kunststoff aufsetzbar, welches Öffnungen 48 aufweist, die mit den Anschlußöffnungen 32 und den Öffnungen 34 korrespondieren. Zum Bereich der Aussparung 12 des Basis-Klemmenträgers 2 hin ist die Abdeckung ferner mit einer seitlichen Nut 50 versehen, welche im Zusammenwirken mit der Nut 28 die Elektronikleiterplatte 14 und das die Elektronikleiterplatte 14 schützende Gehäuse 29 aufnimmt, welches in Steckrichtung SR auf den Basis-Klemmenträger 2 aufsetzbar ist. Führungszapfen am Basis-Klemmenträger unterstützen beim Eingriff in eine zugehörige Öffnung der Nachbarklemme die mechanische Verbindung der aneinandergereihten Klemmenträger.

Der Basis-Klemmenträger 2 bzw. die Modulscheibe MS umfaßt im Bereich der Aussparung 12 an/unterhalb der Grundwandung 52 der Aussparung 12 (von dem Steg 26 aus gesehen nach innen zur Tragschiene hin) folgende Funktionsbereiche:
- Modulbus(öffnung) BUS / 8
- Kennzeichnungskanal (für ein oder zwei Schilder) 54
- seitlicher Rasthaken 56 als Verbindung zur Nachbarklemme mit Öffnung 57 zur Betätigung des Rasthakens von oben 57
- FE-Kontakt (Funktionserde) 58
- Potentialführungs-Kontaktierungsöffnung 59
- Steckerbuchsen/Anschlußöffnungen 44.

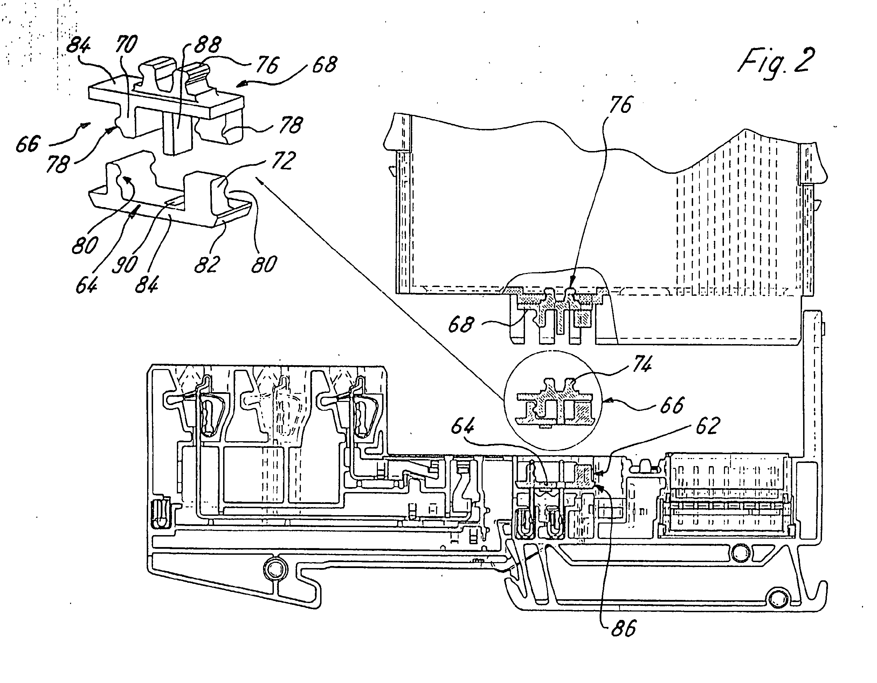

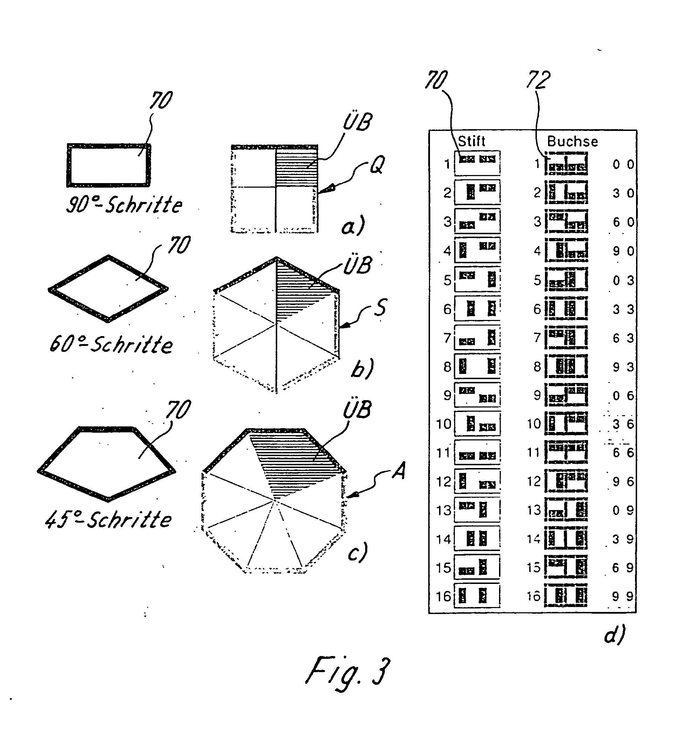

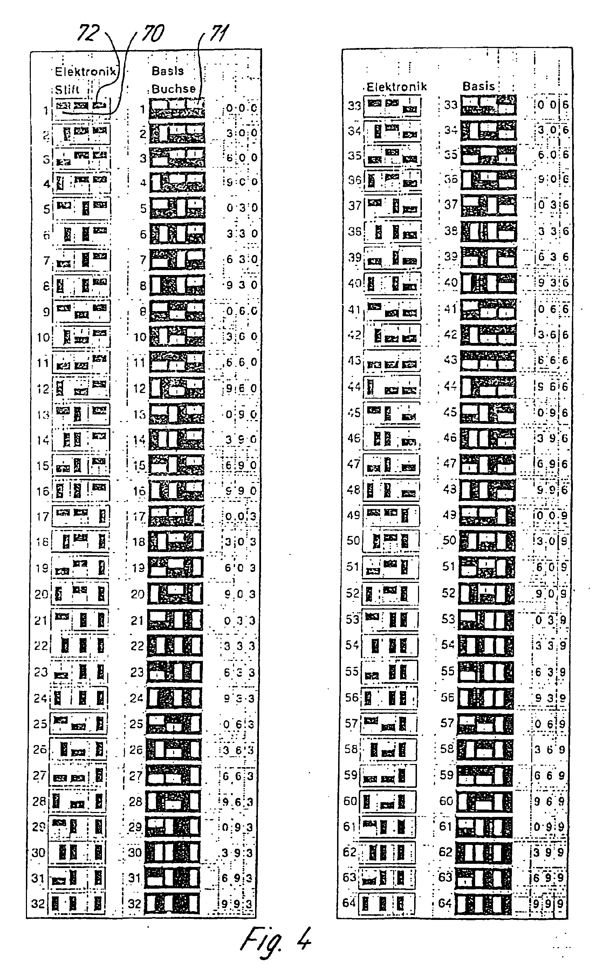

Neben dem FE-Kontakt 58 und den Öffnungen 44 zu den Potentialführungen PE+, PEist in besonders raumsparender Weise eine Ausnehmung 62 für einen unteren Abschnitt 64 eines Kodierelementes 66 vorgesehen, das beim Aufsetzen der Leiterplatte bzw. der Elektronik vom Gehäuse 29 der Elektronikleiterplatte 14 in die Ausnehmung 62 einrastet und damit das Gegenstück für einen an der Elektronikeinheit 12/29 verbleibenden oberen Kodierelementabschnitt 68 bildet. Zur Realisierung der eigentlichen Kodierfunktion sind der obere und der untere Kodierelementabschnitt 64, 68 mit aneinanderliegenden Zapfen 70, 72 versehen, siehe Fig. 2. Alternativ ist es nach Fig. 3 und 4 auch möglich, einen der Kodierelementabschnitte mit zu den Zapfen passenden Buchsen zu versehen. Die Zapfen 70, 72 sind relativ zur Hauptebene (also relativ zur Zeichnungsebene der Fig. 2) entweder im wesentlichen parallel und/oder senkrecht ausgerichtet und erlauben nur bei zusammengehörigen Elementen ein Aufsetzen des Elektronikgehäuses 29 auf den Basis-Klemmenträger 2. Das Elektronikgehäuse 29 (im Sinne des Anspruches 1 das "erste Bauteil" des elektrischen Gerätes) ist nur in einer eindeutig bestimmten Lage auf den Basis-Klemmenkörper 2 ("zweites Bauteil") aufrastbar.

Bei dem ersten Aufsetzen des Elektronikgehäuses 29 auf den Basis-Klemmenträger 2 wird das Kodierelement 66 - also der mit Rastnasen 74 in Ausnehmungen 76 des Elektronikgehäuses 29 verrastete obere Kodierelementabschnitt 68 zusammen mit dem daran anrastenden unteren Kodierelementabschnitt 64 in die Öffnung 62 geführt. An dem oberen Kodierelementabschnitt 68 rastet der untere Kodierelementabschnitt 64 mittels der Rastnasen und Rastausnehmungen 78, 80 an den Zapfen 70, 72 an. Dort hintergreifen angeschrägte Kanten 82 der Grundplatte 84 des unteren Kodierelementabschnittes 64 Hinterschneidungen 86 der Ausnehmung 62 derart, daß beim Abnehmen des Elektronikgehäuses 29 vom Basis-Klemmenträger 2 zwar die Rastnasen 78 und Ausnehmungen 80 an den Zapfen voneinander gelöst werden, nicht aber der untere Kodierelementabschnitt 64 aus dem Basis-Klemmenträger 2. Auf diese Weise kann der Anwender selbst jede gewünschte Elektronikeinheit auf den Basis-Klemmenträger 2 aufsetzen und somit die jeweils notwendige Kodierfunktion verwirklichen. Eine große Lagerhaltung verschiedenster kompletter Modulscheiben entfällt.

Ein am Kodierelement 68 befestigter rechteckiger Stift 88 zum Eingriff in eine Öffnung 90 des zweiten Kodierelementes sorgt für eine Verdrehsicherung der beiden Kodierelemente gegeneinander. Wird anstelle einer Lösung mit aneinanderliegenden Zapfen 70, 72 am ersten und zweiten Kodierelementabschnitt eine solche mit Zapfen 70, 72 und dazu komplementären Buchsen 71 realisiert, sorgt das Ineinandergreifen von Stift und Buchse allein bereits für diese Verdrehsicherung (Fig. 3, 4).

Nach den Varianten der Fig. 3a bzw. 3d sind die Zapfen 70 als halbe Quadratflächen ausgestaltet. Nach den weiteren Varianten 3b und 3c sind die Zapfen 70 als Sektorstücke am Außenumfang einer Sechseck-Grundfläche S (Fig. 3b) oder Achteck-Grundfläche A (Fig. 3c) angeordnet, die bei verschiedenen Kodiervarianten am Umfang um 60° (Sechseck) oder 45° (Achteck) zueinander verdreht sind ("Rotation"). Bei verschiedenen, beispielsweise auch benachbarten, Varianten überlappen sich die Zapfen. In Fig. 3b bilden die Zapfen eine Raute (120°-Element), alternativ sind sie als halbes Sechseck ausführbar (nicht dargestellt). In Fig. 3c bilden die Zapfen 70 ein Fünfeck (135°-Element). Sie können hier auch als halbes Achteck ausgeführt sein (nicht dargestellt). Mit zunehmender Eckenzahl bis hin zum Kreis läßt sich auf diese Weise die Variantenzahl auf einer Grundfläche unkompliziert erhöhen.

Die Art der Anordnung der Zapfen 70, 72 als zueinander senkrechte Vorsprünge bzw. Zapfen insbesondere rechteckigen Querschnitts erlaubt auf engem Raum eine Vielzahl von Kodiervarianten. Hierzu wird auf Fig. 3d und 4 verwiesen. Bei dem in Fig. 3d und 4 dargestellten Kodiersystem weisen die aneinander liegenden Zapfen 70 und Buchsen 71 jeweils im wesentlichen einen rechteckigen Querschnitt aufweisen, der ca. die halbe Fläche eines Quadratbereiches Q der Grundplatte einnimmt, auf dem die Zapfen nach einem Kodiersystem ausgerichtet sind, bei welchem die Zapfen und Buchsen 70, 71, 72 des ersten und des zweiten Kodierelementes jeweils vier verschiedene Positionen einnehmen, wobei im wesentlichen jeweils eine der Längsseiten des Rechteckes an einer der Außenseiten des Quadratbereiches anliegt (0.00 Uhr, 3.00 Uhr, 6.00 Uhr, 9.00 Uhr). In Fig. 2 sind die Grundplatten 84 des ersten und des zweiten Kodierelementabschnittes mit zwei und in Fig. 3 mit drei der aneinander gereihten Quadratbereiche Q zur Aufnahme der rechteckigen Zapfen und Buchsen versehen, wodurch sich die dargestellten 16 bzw. 64 Kodiervarianten auf engem Raum stecksicher realisieren lassen.

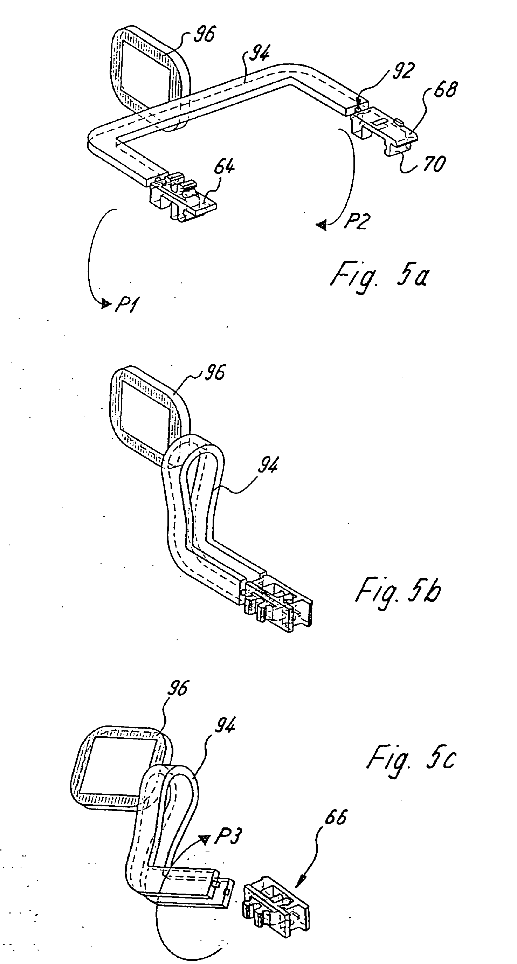

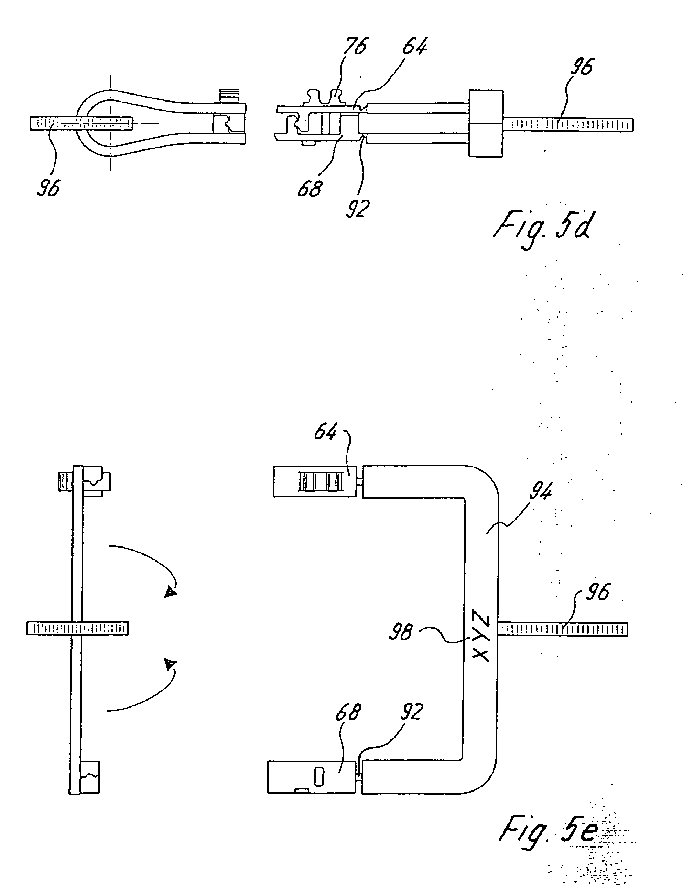

Fig. 5 zeigt eine Ausführungsform der Erfindung, bei welcher die beiden Kodierelementabschnitte 64, 68 jedes Kodierelementes 66 einstückig über Einschnürungen bzw. Abrißkanten 92 mit einem flexiblen, u-förmigen Griff 94 mit Handhabe 96 ausgeformt sind, der eine leichte Montage des Kodierelementes 66 ermöglicht und die Gefahr von Verwechslungen bei der Montage minimiert.

Fig. 5a zeigt wie Fig. 5e die Ausgangslage beim Ergreifen des Griffes 94 nebst der Kodierelementabschnitte 64 und 68. Wie durch die Pfeile P 1 und P2 angedeutet, läßt sich der flache, bandartige Griff 94 von Hand derart zusammenbiegen, daß die beiden Kodierelementabschnitte 64 und 68 zusammenrasten (Fig. 5b). Danach wird das zusammengerastete Kodierelement 66 direkt an ein zu kodierendes Bauteil (z.B das Gehäuse 29 in Fig. 1) angesetzt und es wird durch eine Drehbewegung entsprechend zum Pfeil P3 in Fig. 5c die Einschnürung 92 zerrissen. Derart ist das Kodierelement 66 als ein einziges Element mit nur einem Handgriff an das Elektronikgehäuse 29 aus Fig. 1 ansetzbar. Fehlkodierungen werden auf diese Weise sicher ausgeschlossen. Ferner werden die Lagerhaltung der Kodierelemente und die Montage der Kodierelemente am elektrischen Gerät deutlich vereinfacht. Die Kennzeichnung 98 vereinfacht das Erkennen der ausgewählten Kodiervariante.

Figur 7 zeigt ein weiteres Ausführungsbeispiel der Erfindung, bei welchem wiederum die beiden Kodierelementabschnitte 64, 68 jedes Kodierelementes 66 einstückig über Einschnürungen und Abrißkanten 92 mit einem flexiblen Griff 94 verbunden sind. Die Handhabe 96 ist hier als Einbuchtung des Griffes 94 ausgebildet, was eine besonders kostengünstige Realisation der Handhabe darstellt.

Es ist auch möglich, die Zapfen 70 und die Buchsen 71 als halbe Sechseck-Grundflächen auszubilden, welche am Umfang des Sechseckes in 60°-Schritten rotieren. Diese Variante hat sich in der Praxis als besonders vorteilhaft herausgestellt, da die Ausbildung der Stifte 70 und der Buchsen 71 als halbe Sechseckflächen eine besonders hohe Sicherheit gegen ein versehentliches Zusammenstecken nicht zusammengehöriger Kodiervarianten gewährleistet. Darüber hinaus läßt sich auf engem Raum eine hohe Anzahl verschiedener Kodiervarianten realisieren, die den Anforderungen der meisten Praxisfälle gerecht wird.

Es ist ferner möglich, dass sich die Anschrägungen 100 der seitlich angeschrägten Kanten 82 der Grundplatte 84 des zweiten Kodierelementabschnittes 64, welche beim Einschieben des zweiten Kodierelementabschnittes 64 in die Ausnehmung 62 des Basis-Klemmenkörpers 2 in die Hinterschneidung 86 einrasten, nur knapp über die halbe Breite der Grundplatte 84 und damit gerade derart weit erstrecken, daß es noch möglich ist, den zweiten Kodierelementabschnitt 64 nach einem seitlichen Verschieben am Basis-Klemmenträger 2 von diesem senkrecht nach oben abzuziehen (was möglich ist, da der Basis-Klemmenträger 2 insgesamt und insbesondere in diesem Bereich etwas schmaler ist als die gesamte Modulscheibe MS nach Art der Fig. 1 mit den darauf aufgesetzten Abdeckungen 29,46). Damit kann der zweite Kodierelementabschnitt 64 durch einen bewußt ausgeführten Arbeitsgang gelöst werden. Lediglich das versehentliche Abziehen vom Basis-Klemmenträger 2 senkrecht nach oben ist ausgeschlossen. Ein unten an die Grundplatte 84 angeformter Vorsprung 102 ist ferner dazu ausgelegt, in eine entsprechend ausgebildete Ausnehmung (nicht dargestellt) am Basis-Klemmenträger 2 einzurasten, so daß auch ein versehentliches seitliches Verschieben am Basis-Klemmenträger 2 verhindert wird. Ein bewußtes Verschieben z.B. mit Hilfe eines Schraubendrehers ist dagegen möglich.

### Bezugszeichen

- Modulscheibe: MS
- Anschlußebenen: A, B, C, ...
- Mehrfachanschlüsse: A1, A2, B2, B2, ...
- Schutzerde: PE
- Funktionserde: FE
- Stromzuführschienen: SP, SSI, SPE
- Steckrichtung: SR
- Quadratbereich: Q
- Sechseck: S
- Achteck: A

- Basis-Klemmenträger: 2
- Kunststoff-Rastfüße: 4
- Basisabschnitt: 6
- Busleiteröffnung: 8
- Interner Busleiterabschnitt: 10
- Umfangs-Ausnehmung: 12
- Elektronik-Leiterplatte: 14
- Öffnungen: 16, 17, 18
- Kontaktelemente: 20, 22
- Stecker: 24
- Steg: 26.
- Einschubnut: 28
- Elektronikgehäuse (E/A-Modulgehäuse): 29
- Anschlußabschnitt: 30
- Runde Öffnungen: 32
- Quadratische Öffnungen: 34
- Feder-Kontaktelemente: 36
- Öffnung: 38
- Kontaktelement: 40
- Aussparungen: 42
- Anschlußöffnungen: 44
- Abdeckgehäuse: 46
- Öffnungen: 48
- Nut: 50
- Grundwandung: 52
- Kennzeichnungskanal: 54
- Öffnung: 57
- FE-Kontakt: 58
- Potential-Kontaktierungsöffnung: 59
- Öffnung: 61
- Ausnehmung: 62
- unterer Kodierlelementabschnitt: 64
- Kodierelement: 66
- oberer Kodierlelementabschnitt: 68
- Zapfen: 70, 72
- Buchsen: 71
- Rastnasen: 74
- Ausnehmungen: 76
- Rastnasen: 78
- Rastausnehmungen: 80
- Kanten: 82
- Grundplatte: 84
- Hinterschneidungen: 86
- Stift: 88
- Öffnung: 90
- Einschnürungen: 92
- Griff: 94
- Handhabe: 96
- Kennzeichnung: 98
- Anschrägungen: 100
- Vorsprung: 102

## Patentansprüche

1. Kodiervorrichtung für ein elektrisches Gerät, wobei das elektrische Gerät ein erstes Bauteil (14, 29) mit einem ersten Kodierelementabschnitt (68) und ein mit dem ersten Bauteil (14, 29) insbesondere in einer eindeutigen Positionszuordnung verbindbares zweites Bauteil (2) mit einem zweiten Kodierelementabschnitt (64) aufweist, der mit dem ersten Kodierelementabschnitt (68) zu einem übergreifenden Kodierelement (66) zusammensetzbar ist, **dadurch gekennzeichnet, dass** eine Grundplatte (84) des zweiten Kodierelementabschnittes (64) mit seitlich angeschrägten Kanten (82) versehen ist, welche beim Einschieben des zweiten Kodierelementabschnittes (64) in eine Ausnehmung (62) des zweiten Bauteiles (2) in eine Hinterschneidung (86) einrasten.

2. Kodiervorrichtung nach Anspruch 1, **dadurch gekennzeichnet, dass** der Kodierelementabschnitt (64, 68) des ersten Bauteiles (29) wenigstens einen Zapfen (70, 72) aufweist, der dazu ausgelegt ist, beim Zusammensetzen der beiden Bauteile (2, 29) an einem entsprechenden Zapfen (70, 72) oder in einer entsprechenden Buchse (71) des Kodierelementabschnittes für das zweite Bauteil (2) geführt zu werden, wobei die zusammensteckbaren Zapfen (70, 72) und/oder Buchsen (71) jeweils im wesentlichen einen mehreckigen Querschnitt aufweisen und einen Teil einer Grundfläche - insbesondere ein regelmäßiges Vieleck (Q,S,A) oder eine Kreisfläche - bilden, auf der sie nach einem Kodiersystem ausgerichtet sind, bei welchem die Zapfen (70, 72) des ersten und die Zapfen (70, 72) und/oder Buchsen (71) des zweiten Kodierelementes (68, 64) jeweils mit einer ihrer Außenseiten im wesentlichen am Umfang der Grundfläche anliegen und bei verschiedenen Kodierelementvarianten am Umfang der Grundfläche umlaufend rotieren bzw. zueinander verdreht sind.

3. Kodiervorrichtung nach Anspruch 2, **dadurch gekennzeichnet, daß** die zusammensteckbaren Zapfen (70,72) und/oder Buchsen (71) jeweils im Wesentlichen einen rechteckigen Querschnitt aufweisen, der ungefähr die halbe Fläche der als Quadratbereich ausgebildeten Grundfläche beträgt.

4. Kodiervorrichtung nach Anspruch 2, **dadurch gekennzeichnet, daß** die Grundfläche als Sechseck (S) ausgebildet ist, wobei die Zapfen (70) als halbe Sechseckfläche oder als Drittel der Sechseckfläche (135°-Element) ausgebildet sind und für verschiedene Kodiervarianten die Stifte (70) bevorzugt jeweils in 60°-Schritten am Außenumfang zueinander versetzt sind.

5. Kodiervorrichtung nach Anspruch 2, **dadurch gekennzeichnet, daß** die Grundfläche als Achteck (A) ausgebildet ist, wobei die Zapfen (70) als halbe Achteckfläche oder als Viertel der Achteckfläche (90°-Element) ausgebildet sind und für verschiedene Kodiervarianten die Stifte (70) bevorzugt jeweils in 45°-Schritten am Außenumfang zueinander versetzt sind.

6. Kodiervorrichtung nach einem der vorstehenden Ansprüche, **dadurch gekennzeichnet, daß** sich die Flächen der verschiedenen Zapfen-/Zapfen oder Zapfen-/Buchsenkombinationen teilweise überlappen.

7. Kodiervorrichtung nach einem der vorstehenden Ansprüche, **dadurch gekennzeichnet, daß** jeweils wenigstens eine der Längsseiten der insbesondere rechteckigen Zapfen (70,72) oder Buchsen (71) an einer der Außenseiten des Quadratbereiches liegt (vorzugsweise 0.00 Uhr, 3.00 Uhr, 6.00 Uhr, 9.00 Uhr-Stellung).

8. Kodiervorrichtung nach einem der vorstehenden Ansprüche, **dadurch gekennzeichnet, daß** die Grundplatten (84) des ersten und des zweiten Kodierelementabschnittes mit mehreren - insbesondere in einer Reihe - aneinander gereihten Quadratbereichen (Q) zur Aufnahme der rechteckigen Zapfen und Buchsen (70, 72, 71) versehen sind.

9. Kodiervorrichtung nach einem der vorstehenden Ansprüche, **dadurch gekennzeichnet, daß** die Zapfen und/oder Buchsen mit Rastnasen (78) und/oder Rastausnehmungen (80) versehen sind, welche beim Zusammenschieben des ersten und des zweiten Kodierelementabschnittes den zweiten Kodierelementabschnitt (64) am ersten Kodierelementabschnitt (68) verrasten.

10. Kodiervorrichtung nach einem der vorstehenden Ansprüche, **gekennzeichnet durch** eine Auslegung derart, daß die Kraft zum Lösen des zweiten Kodierelementabschnittes (64) aus einer Ausnehmung des zweiten Bauteiles (2) größer ist als die Kraft zum Lösen des zweiten Kodierelementabschnittes (64) vom ersten Kodierelementabschnitt (68).

11. Kodiervorrichtung nach einem der vorstehenden Ansprüche, **dadurch gekennzeichnet, daß** die zwei Kodierelementabschnitte gemeinsam an das erste Bauteil (14, 29) ansetzbar und derart ausgelegt sind, daß beim Zusammenfügen der beiden Bauteile (14, 29, 2) der zweite Kodierelementabschnitt (64) derart an das zweite Bauteil (2) anrastet, daß beim Trennen der beiden Bauteile (14, 29, 2) voneinander der zweite Kodierelementabschnitt (64) am zweiten Bauteil (2) verbleibt, so daß er ein Gegenstück für den beim Trennen der zwei Bauteile (14, 29, 2) am ersten Bauteil (14, 29) verbleibenden ersten Kodierelementabschnitt (68) bildet.

12. Kodiervorrichtung nach einem der vorstehenden Ansprüche, **dadurch gekennzeichnet, daß** das elektrische Gerät als erstes Bauteil eine Elektronikeinheit, vorzugsweise mit Leiterplatte (14) und Elektronikgehäuse (29), und als zweites Bauteil einen Basis-Klemmenkörper (2) zum Aufrasten auf eine Tragschiene aufweist, wobei die Elektronikeinheit in eine Ausnehmung (12) des Basis-Klemmenkörpers (2) einschiebbar ist.

13. Kodiervorrichtung nach Anspruch 12, **dadurch gekennzeichnet, daß** sich Anschrägungen (100) der seitlich angeschrägten Kanten (82) der Grundplatte (84) des zweiten Kodierelementabschnittes (64), welche beim Einschieben des zweiten Kodierelementabschnittes (64) in die Ausnehmung (62) des Basis-Klemmenkörpers (2) in die Hinterschneidung (86) einrasten, derart erstrecken, daß der zweite Kodierelementabschnitt (64) nach einem seitlichen Verschieben am Basis-Klemmenträger (2) von diesem senkrecht nach oben abziehbar ist.

14. Kodiervorrichtung nach Anspruch 12 oder 13, **dadurch gekennzeichnet, daß** unten an die Grundplatte (84) ein Vorsprung (102) zum Eingriff in eine entsprechend ausgebildete Ausnehmung am Basis-Klemmenträger (2) angeformt ist.

15. Kodiervorrichtung nach einem der vorstehenden Ansprüche, **dadurch gekennzeichnet, daß** die ineinander greifenden Zapfen und/oder Buchsen (70, 72, 71) des ersten und des zweiten Kodierelementabschnittes (68, 64) relativ zur Hauptebene des Basis-Klemmenkörpers (2) im wesentlichen parallel und/oder senkrecht ausgerichtet sind.

16. Kodiervorrichtung nach einem der vorstehenden Ansprüche, **dadurch gekennzeichnet, daß** der erste Kodierelementabschnitt (68) lösbar an der Elektronikeinheit befestigt ist.

17. Kodiervorrichtung nach einem der vorstehenden Ansprüche, **dadurch gekennzeichnet, daß** am ersten Kodierelementabschnitt (68) ein eckiger Stift (88) befestigt ist, der zum Eingriff in eine korrespondierende Öffnung (90) des zweiten Kodierelementabschnittes ausgelegt ist.

18. Kodiervorrichtung nach einem der vorstehenden Ansprüche, **dadurch gekennzeichnet, daß** die beiden Kodierelementabschnitte (64, 68) jedes Kodierelementes (66) einstückig über Einschnürungen bzw. Abrißkanten (92) mit einem Grundkörper, insbesondere einem flexiblen Griff (94) - verbunden sind, an dem die beiden Kodierelementabschnitte (64, 68) jeweils zu einem der Kodierelemente (66) zusammensetzbar sind.

19. Kodiervorrichtung nach Anspruch 18, **dadurch gekennzeichnet, daß** der Griff (94) als bandartiger, u-förmiger Kunststoffbügel ausgebildet ist.

20. Kodiervorrichtung nach Anspruch 18 oder 19, **dadurch gekennzeichnet, daß** die Einschnürung (92) derart ausgebildet ist, daß das zusammengesetzte Kodierelement (66) durch eine Drehbewegung vom Griff (94) abtrennbar ist.

21. Kodiervorrichtung nach einem der vorstehenden Ansprüche 18 bis 20, **dadurch gekennzeichnet, daß** der Griff (94) mit einer Handhabe (96) versehen ist.

22. Kodiervorrichtung nach einem der vorstehenden Ansprüche 18 bis 21, **dadurch gekennzeichnet, daß** der Griff (94) und/oder die Handhabe (96) mit einer Kennzeichnung (98) versehen ist.

23. Kodiervorrichtung nach einem der vorstehenden Ansprüche 18 bis 22, **dadurch gekennzeichnet, daß** zur Herstellung der verschiedenen Varianten von Kodierelementen (66) eine einzige Gußform mit einer der Anzahl an Kodiervarianten entsprechenden Anzahl an Ausnehmungen vorgesehen ist.

24. Kodiervorrichtung nach einem der vorstehenden Ansprüche, **dadurch gekennzeichnet, daß** die verschiedenen Kodierelemente (66) entsprechend zu ihrer Häufigkeitsverteilung beim jeweiligen Einsatzweck im Gußwerkzeug zu Gruppen zusammengestellt sind.

25. Verfahren zur Kodierung zweiter Bauteile eines elektrischen Gerätes mit einer Kodiervorrichtung nach einem der vorstehenden Ansprüche 18 bis 24, **dadurch gekennzeichnet, daß**
a. der flache, bandartige Griff derart zusammengebogen wird, daß die beiden mit dem Griff verbundenen Kodierelementabschnitte zusammenrasten (Pfeile P1 und P2),
b. das zusammengesetzte Kodierelement an eines der Bauteile des elektrischen Gerätes angesetzt wird, und
c. vorzugsweise durch eine weitere Drehbewegung (Pfeil P3) mindestens eine Einschnürung durchtrennt wird.

## Claims

1. A coding apparatus for an electrical device, the electrical device having a first component (14, 29) with a first coding element section (68) and a second component (2), which can be connected to the first component (14, 29) in particular in a specific allocated position, with a second coding element section (64) which can be fitted together with the first coding element section (68) to form a composite coding element (66),
**characterised in that**
a base plate (84) of the second coding element section (64) is provided with laterally angled edges (82) which engage in an undercut (86) when the second coding element section (64) is inserted into recess (62) in the second component (2).

2. A coding apparatus in accordance with claim 1,
**characterised in that**
the coding element section (64, 68) of the first component (29) has at least one pin (70, 72) which is designed to be held in a corresponding pin (70, 72) or a corresponding bush (71) in the coding element section for the second component (2) when the two components (2, 29) are fitted together, the engaging pins (70, 72) and/or bush (71) each essentially having a polygonal cross-section and forming a part of an area - in particular a regular polygon (Q, S, A) or a circular area - on which they are positioned in accordance with a coding system in which the external sides of the pins (70, 72) on the first and the pins (70, 72) and/or bushes (71) on the second coding element (68, 64) lie essentially adjacent to the periphery of the area and rotate or are rotated in relation to one another around the periphery of the area in different coding element variants.

3. A coding apparatus in accordance with claim 2,
**characterised in that**
the engaging pins (70, 72) and/or bushes (71) each have an essentially rectangular cross-section which covers approximately half of the surface of the area which is designed as a quadratic area.

4. A coding apparatus in accordance with claim 2,
**characterised in that**
the area is designed as a hexagon (S), the pins (70) being designed as half hexagons or third hexagons (135° element) and preferably being offset in 60° steps in relation to one another around the outer periphery for different coding variants.

5. A coding apparatus in accordance with claim 2,
**characterised in that**
the area is designed as an octagon (S), the pins (70) being designed as half octagons or quarter octagons (90° element) and preferably being offset in 45° steps in relation to one another around the outer periphery for different coding variants.

6. A coding apparatus in accordance with one of the preceding claims,
**characterised in that**
the faces of the various pin/pin or pin/bush combinations overlap partially.

7. A coding apparatus in accordance with one of the preceding claims,
**characterised in that**
at least one of the longitudinal sides of the particularly rectangular pins (70, 72) or bushes (71) lies on one of the external sides of the quadratic area (preferably at 12 o'clock, 3 o'clock, 6 o'clock and 9 o'clock).

8. A coding apparatus in accordance with one of the preceding claims,
**characterised in that**
the base plates (84) of the first and second coding element sections are provided with several adjacent quadratic areas (Q) - in particular in a row-for receiving the rectangular pins and bushes (70, 72, 71).

9. A coding apparatus in accordance with one of the preceding claims,
**characterised in that**
the pins and/or bushes are provided with projections (78) and/or recesses (80) which lock the second coding element section (64) to the first coding element section (68) when the first and second coding element sections are pushed together.

10. A coding apparatus in accordance with one of the preceding claims,
**characterised by**
a design in which the force required to release the second coding element section (64) from a recess in the second component (2) is greater than the force required to release the second coding element section (64) from the first coding element section (68).

11. A coding apparatus in accordance with one of the preceding claims,
**characterised in that**
the two coding element sections can be fixed onto the first component (14, 29) together and are designed in such a manner that when the two components (14, 29, 2) are joined together the second coding element section (64) engages with the second component (2) in such a manner that when the two components (14, 29, 2) are separated from one another the second coding element section (64) remains on the second component (2), thereby forming a counterpart for the first coding element section (68) which remains on the first component (14, 29) when the second component (14, 29, 2) is separated.

12. A coding apparatus in accordance with one of the preceding claims,
**characterised in that**
the electrical device has an electronics unit, preferably with printed circuit boards (14) and an electronics housing (29), as the first component and a base terminal body (2) to clip onto a mounting rail as the second component, it being possible to insert the electronics unit into a recess (12) in the base terminal body (2).

13. A coding apparatus in accordance with claim 12,
**characterised in that**
angled sections (100) in the laterally angled edges (82) of the base plate (84) of the second coding element section (64) which engage in the undercut (86) when the second coding element section (64) is pushed into the recess (62) in the base terminal body (2) extend in such a manner that the second coding element section (64) can be pulled off the base terminal body (2) vertically upwards when the latter is moved laterally.

14. A coding apparatus in accordance with claim 12 or 13,
**characterised in that**
formed onto the base plate (84) at the bottom is a projection (102) which engages in a correspondingly designed recess in the base terminal body (2).

15. A coding apparatus in accordance with one of the preceding claims,
**characterised in that**
the interlocking pins and/or bushes (70, 72, 71) on the first and second coding element sections (68, 64) are aligned essentially parallel and/or perpendicular to one another in relation to the main plane of the base terminal body (2).

16. A coding apparatus in accordance with one of the preceding claims,
**characterised in that**
the first coding element section (68) is fixed to the electronics unit in such a manner that it can be detached.

17. A coding apparatus in accordance with one of the preceding claims,
**characterised in that**
fixed on the first coding element section (68) is a polygonal pin (88) which is designed to engage in a corresponding opening (90) in the second coding element section.

18. A coding apparatus in accordance with one of the preceding claims,
**characterised in that**
the two coding element sections (64, 68) of each coding element (66) are joined together in one piece by means of necks or tear-off edges (92) to a base body, in particular a flexible grip (94), on which the two coding element sections (64, 68) can be assembled to form one of the coding elements (66).

19. A coding apparatus in accordance with claim 18,
**characterised in that**
the grip bar (94) is designed as a strip-like, U-shaped plastic strap.

20. A coding apparatus in accordance with claim 18 or 19,
**characterised in that**
the neck (92) is designed in such a manner that the assembled coding element (66) can be separated from the grip (94) by means of a rotational movement.

21. A coding apparatus in accordance with one of preceding claims 18 to 20,
**characterised in that**
the grip (94) is provided with a handle (96).

22. A coding apparatus in accordance with one of preceding claims 18 to 21,
**characterised in that**
the grip (94) and/or the handle (96) is/are labelled.

23. A coding apparatus in accordance with one of preceding claims 18 to 22,
**characterised in that**
one single casting mould with a number of recesses corresponding to the number of coding variants is provided for the manufacture of the various variants of the coding elements (66).

24. A coding apparatus in accordance with one of preceding claims,
**characterised in that**
the various coding elements (66) are combined in groups in the casting mould according to their frequency of distribution in each application.

25. A process for coding two components of an electrical device with a coding apparatus in accordance with one of preceding claims 18 to 24,
**characterised in that**
a. the flat, strip-like grip is folded together in such a manner that the two coding element sections connected to the grip engage in one another (arrows P1 and P2),
b. the assembled coding element is fitted to one of the components of the electrical device, and
c. at least one neck is separated preferably by a further rotational movement (arrow P3).

## Revendications

1. Dispositif de codage pour un appareil électrique, ledit appareil électrique comportant une première pièce (14, 29) avec une première partie d'élément de codage (68) et une deuxième pièce (2) apte à être reliée à la première pièce (14, 29), en particulier dans une correspondance de position univoque, et munie d'une deuxième partie d'élément de codage (64), qui peut être assemblée à la première partie d'élément de codage (68) pour former un élément de codage (66) chevauchant, **caractérisé en ce qu'**une plaque de base (84) de la deuxième partie d'élément de codage (64) est munie de bords (82) chanfreinés latéralement, lesquels, lors de l'introduction de la deuxième partie d'élément de codage (64) dans un évidement (62) de la deuxième pièce (2), viennent se bloquer dans un détalonnage (86).

2. Dispositif de codage selon la revendication 1, **caractérisé en ce que** la partie d'élément de codage (64, 68) de la première pièce (29) comporte au moins un tenon (70, 72) qui est conçu pour être guidé, lors de l'assemblage des deux pièces (2, 29), contre un tenon (70, 72) correspondant ou dans une douille (71) correspondante de la partie d'élément de codage pour la deuxième pièce (2), les tenons (70, 72) et/ou la douille (71) enfichables l'un dans l'autre ayant sensiblement chacun une section polygonale et formant une partie d'une surface de base -en particulier un polygone régulier (Q, S, A) ou une surface circulaire-, sur laquelle ils sont orientés selon un système de codage, dans lequel les tenons (70, 72) du premier élément de codage (68) et les tenons (70, 72) et/ou douilles (71) du deuxième élément de codage (64, 68) sont en appui chacun avec une de leurs faces extérieures sensiblement contre la périphérie de la surface de base et, dans différentes variantes d'éléments de codage, tournent tout autour de la périphérie de la surface de base et sont décalés les uns par rapport aux autres.

3. Dispositif de codage selon la revendication 2, **caractérisé en ce que** les tenons (70, 72) et/ou les douilles (71) enfichables l'un dans l'autre ont sensiblement chacun une section rectangulaire, qui correspond environ à la moitié de la surface de la surface de base réalisée sous forme de zone carrée.

4. Dispositif de codage selon la revendication 2, **caractérisé en ce que** la surface de base est réalisée sous forme d'hexagone (S), les tenons (70) étant réalisés sous la forme d'une moitié de surface hexagonale ou sous la forme d'un tiers de surface hexagonale (élément de 135°) et, pour différentes variantes de codage, les broches (70) sont décalées de préférence les unes par rapport aux autres selon un pas de 60° sur la périphérie extérieure.

5. Dispositif de codage selon la revendication 2, **caractérisé en ce que** la surface de base est réalisée sous forme d'octogone (A), les tenons (70) étant réalisés sous la forme d'une moitié de surface octogonale ou sous la forme d'un quart de surface octogonale (élément de 90°) et, pour différentes variantes de codage, les broches (70) sont décalées de préférence les unes par rapport aux autres selon un pas de 45° sur la périphérie extérieure.

6. Dispositif de codage selon l'une des revendications précédentes, **caractérisé en ce que** les surfaces des différentes combinaisons tenon/tenon ou tenon/douille se chevauchent partiellement.

7. Dispositif de codage selon l'une des revendications précédentes, **caractérisé en ce que** dans chaque cas au moins un des côtés longitudinaux des tenons (70, 72) ou douilles (71) en particulier rectangulaires est en appui contre un des côtés extérieurs de la zone carrée (par exemple, dans la position 0h,3h,6h,9h).

8. Dispositif de codage selon l'une des revendications précédentes, **caractérisé en ce que** les plaques de base (84) de la première et de la deuxième partie d'élément de codage sont munies de plusieurs zones carrées (Q) en enfilade - en particulier en une rangée - destinées à recevoir les tenons et douilles (70, 72, 71) rectangulaires.

9. Dispositif de codage selon l'une des revendications précédentes, **caractérisé en ce que** les tenons et/ou douilles sont munis d'ergots de blocage (78) et/ou d'évidements de blocage (80) qui, lors du coulissement de la première et de la deuxième partie d'élément de codage l'une dans l'autre, bloquent la deuxième partie d'élément de codage (64) contre la première partie d'élément de codage (68).

10. Dispositif de codage selon l'une des revendications précédentes, **caractérisé par** une conception telle que la force pour détacher la deuxième partie d'élément de codage (64) hors d'un évidement de la deuxième pièce (2) est supérieure à la force pour détacher la deuxième partie d'élément de codage (64) de la première partie d'élément de codage (68).

11. Dispositif de codage selon l'une des revendications précédentes, **caractérisé en ce que** les deux parties d'élément de codage peuvent être montées conjointement sur la première pièce (14, 29) et sont conçues de telle sorte que, lors de l'assemblage des deux pièces (14, 29, 2), la deuxième partie d'élément de codage (64) est bloquée sur la deuxième pièce (2) de telle sorte que, lors de la séparation l'une de l'autre des deux pièces (14, 29, 2), la deuxième partie d'élément de codage (64) reste sur la deuxième pièce (2), de telle sorte qu'elle forme une partie complémentaire pour la première partie d'élément de codage (68) restant sur la première pièce (14, 29) lors de la séparation des deux pièces (14, 29, 2).

12. Dispositif de codage selon l'une des revendications précédentes, **caractérisé en ce que** l'appareil électrique comporte, en tant que première pièce, une unité électronique, de préférence avec une plaquette de circuits imprimés (14) et un boîtier (29), et, en tant que deuxième pièce, un corps de raccordement de base (2) destiné à être monté sur un rail support, l'unité électronique pouvant être insérée dans un évidement (12) du corps de raccordement de base (2).

13. Dispositif de codage selon la revendication 12, **caractérisé en ce que** des chanfreins (100) des bords (82) latéralement chanfreinés de la plaque de base (84) de la deuxième partie d'élément de codage (64), lesquels se bloquent dans le détalonnage (86) au moment de l'introduction de la deuxième partie d'élément de codage (64) dans l'évidement (62) du corps de raccordement de base (2), s'étendent de telle sorte que la deuxième partie d'élément de codage (64), après un coulissement latéral sur le corps de raccordement de base (2), peut être retirée de ce dernier perpendiculairement vers le haut.

14. Dispositif de codage selon la revendication 12 ou 13, **caractérisé en ce qu'**une saillie (102) est formée en bas sur la plaque de base (84) pour entrer en prise dans un évidement de forme correspondante sur le corps de raccordement de base (2).

15. Dispositif de codage selon l'une des revendications précédentes, **caractérisé en ce que** les tenons et/ou douilles (70, 72, 71), s'enfichant l'un dans l'autre, de la première et de la deuxième partie d'élément de codage (68, 64) sont orientés sensiblement parallèlement et/ou perpendiculairement par rapport au plan principal du corps de raccordement de base (2).

16. Dispositif de codage selon l'une des revendications précédentes, **caractérisé en ce que** la première partie d'élément de codage (68) est fixée de manière amovible sur l'unité électronique.

17. Dispositif de codage selon l'une des revendications précédentes, **caractérisé en ce qu'**une broche (88) polygonale, qui est conçue pour s'engager dans une ouverture (90) correspondante de la deuxième partie d'élément de codage, est fixée sur la première partie d'élément de codage (68).

18. Dispositif de codage selon l'une des revendications précédentes, **caractérisé en ce que** les deux parties d'élément de codage (64, 68) de chaque élément de codage (66) sont reliées d'un seul tenant, par l'intermédiaire de rétrécissements ou de bords de rupture (92), à un corps de base, en particulier une poignée (94) flexible, sur laquelle les deux parties d'élément de codage (64, 68) peuvent être assemblées dans chaque cas pour former l'un des éléments de codage (66).

19. Dispositif de codage selon la revendication 18, **caractérisé en ce que** la poignée (94) est réalisée sous la forme d'un arceau en forme de U formé par une bande en matière plastique.

20. Dispositif de codage selon la revendication 18 ou 19, **caractérisé en ce que** le rétrécissement (92) est réalisé de telle sorte que l'élément de codage (66) assemblé peut être séparé de la poignée (94) par un mouvement de rotation.

21. Dispositif de codage selon l'une des revendications 18 à 20, **caractérisé en ce que** la poignée (94) est munie d'une manette (96).

22. Dispositif de codage selon l'une des revendications 18 à 21, **caractérisé en ce que** la poignée (94) et/ou la manette (96) sont munies d'une identification (98).

23. Dispositif de codage selon l'une des revendications 18 à 22, **caractérisé en ce que**, pour la réalisation des différentes variantes d'éléments de codage (66), il est prévu un seul moule avec un nombre d'évidements correspondant au nombre de variantes de codage.

24. Dispositif de codage selon l'une des revendications précédentes, **caractérisé en ce que** les différents éléments de codage (66) sont rassemblés dans le moule en groupes correspondant à la distribution de fréquence de chaque fin d'utilisation.

25. Procédé de codage de deux pièces d'un appareil électrique comportant un dispositif de codage selon l'une des revendications 18 à 24, **caractérisé en ce que**
a) la poignée plate en forme de bande est courbée de telle sorte que les deux parties d'élément de codage, reliées par la poignée, sont bloquées entre elles (flèches P1 et P2),
b) l'élément de codage assemblé est monté sur l'une des pièces de l'appareil électrique, et
c) au moins un rétrécissement est sectionné de préférence par un autre mouvement de rotation (flèche P3).
